# FASCICULE DE BREVET EUROPEEN

(11) **EP 1 078 391 B1**
(45) Date de publication et mention de la délivrance du brevet: **13.08.2003**
(21) Numéro de dépôt: 99916975.8
(22) Date de dépôt: 03.05.1999
(51) Int. Cl.: H01L 21/00

(54) **PROCEDE ET DISPOSITIF DE CHANGEMENT DE POSITION D'UNE PLAQUE DE SEMI-CONDUCTEUR**
LAGEVERÄNDERUNGS-VORRICHTUNG UND -VERFAHREN FÜR EINE HALBLEITERSCHEIBE
METHOD AND DEVICE FOR CHANGING A SEMICONDUCTOR WAFER POSITION

(30) Priorité: 05.05.1998 FR 9805660
(43) Date de publication de la demande: 28.02.2001
(73) Titulaire: RECIF S.A., 31840 Aussonne (FR)
(72) Inventeur: ASTEGNO, Pierre, F-31790 Saint Jory (FR); ESTEVE, Ekaterina, F-31000 Toulouse (FR); GAUDON, Alain, F-31330 Launac (FR)
(74) Mandataire: Morelle, Guy Georges Alain
(86) Numéro de dépôt international: FR9901045
(87) Numéro de publication internationale: WO99057752

(56) Documents cités:
- US-A- 5 102 291
- US-A- 5 445 486

## Description

La présente invention se rapporte aux domaines de la fabrication des composants électroniques, notamment la fabrication des circuits intégrés à partir de substrats ou plaques en matériaux semi-conducteurs comme le silicium, plus particulièrement aux procédés mécaniques et dispositifs permettant un changement de position d'au moins une plaque de semi-conducteur munie d'au moins un repère de positionnement et placée dans un support destiné à loger une pluralité de plaques de semi-conducteur,

L'art antérieur enseigne de tels procédés qui consistent notamment à saisir la plaque de semi-conducteur par une de ses faces pour changer sa position, notamment la déplacer d'un lieu à un autre, les dispositifs permettant de mettre en oeuvre ces procédés comprenant des moyens autorisant une saisie de la plaque par aspiration dans la zone centrale d'une face de cette dernière. Indépendamment du déplacement des plaques d'un lien à un autre, les plaques de semiconducteur sont orientées de manière à placer leur repère de positionnement dans une position déterminée, cette dernière opération pouvant consister par exemple à aligner les repères de positionnement de toutes les plaques destinées à être placées ou se trouvant dans un support commun.

Les procédés et dispositifs de l'art antérieur présentent l'inconvénient de permettre une contamination des plaques de semi-conducteur du fait d'une prise de ces dernières par une de leurs faces qui sont constituées d'un matériau très sensible aux contaminations diverses, d'autant plus importantes qu'il y a contact de la face avec un objet. Les procédés et dispositifs de l'art antérieur présentent en outre des durées importantes pour le déroulement des opérations de déplacement et d'orientation d'une plaque ou des plaques de semi-conducteur, ces opérations étant gérées de manière indépendante, ce qui induit des durées de traitement plus importantes pour les plaques de semi-conducteur, et donc des coûts de traitement plus élevés.

On connaît le document US 5,102,291 qui se rapporte à un procédé et une machine pour orienter une plaque de silicium se trouvant dans un support en la saisissant par sa partie périphérique afin de minimiser des contaminations éventuelles qu'elle pourrait subir par un contact direct avec ses faces. Les plaques sont saisies une à une entre deux bras de préhension mobiles en translation l'un par rapport à l'autre suivant une droite, qui sont rapprochés l'un de l'antre suivant la direction de guidage en translation jusqu'à ce que les deux bras viennent en pression contre la partie périphérique de la plaque à saisir par l'intermédiaire de quatre galets presseurs qui soulèvent la plaque avant le contact des galets contre la partie périphérique de cette dernière, la plaque de silicium saisie pouvant être orientée en rotation dans une position particulière par rapport au support aux moyens des galets presseurs tournant dans le plan de la plaque et dont au moins un peut être motorisé. La machine permet en outre un déplacement de la plaque saisie limité à une droite du fait des deux bras de préhension. La détection de l'orientation désirée de la plaque peut se faire par un moyen de capteur mécanique, optique électrique, ou autre. Pour les plaques munies d'une encoche, le document préconise une tige plus petite que l'encoche qui pénétrerait dans l'encoche lorsque la plaque est dans la position désirée.

On connaît également le document US 5,445,486 qui se rapporte à une machine de transfert de plaques de silicium d'un support à un autre, au moyen d'un bras de préhension inséré entre les plaques dans un support, le bras saisissant une ou plusieurs plaques par la partie périphérique de leur face inférieure. La machine ne dispose pas de moyen d'orientation des plaques transférées.

Les traitements de plaques de semi-conducteur visés peuvent être tous traitements nécessitant un changement de position d'une plaque, de plusieurs plaques, on de la totalité des plaques de semi-conducteur placées dans un support commun, par exemple transfert de plaques d'un support à un autre, alignement des repères en vue d'une identification respective des plaques dans le support, ou simplement modification de la position angulaire de plaque de semi-conducteur se trouvant dans un support, en vue d'un placement des repères dans une position déterminée.

La présente invention selon les revendications 1 et 5 propose de pallier les inconvénients ci-dessus, et d'apporter d'autres avantages. Un objet de la présente invention est de permettre un changement de position d'au moins une plaque de semi-conducteur en évitant toute contamination due à une saisie de la plaque par une de ses faces, et en réduisant en outre les risques de contaminations.

Un autre objet de la présente invention est de permettre un changement de position d'au moins une plaque de semi-conducteur permettant de modifier l'orientation d'une plaque simultanément à une autre opération de traitement, notamment un déplacement, ou un transfert de la plaque.

Un autre objet de la présente invention est de permettre un gain d'espace dans une station de traitement de plaque de semi-conducteur, en évitant une installation spécifique pour l'orientation ou l'alignement des repères de positionnement des plaques.

Un autre objet de la présente invention est de permettre une saisie et une orientation d'une pluralité de plaques de semi-conducteur, l'orientation des plaques étant effectuée de manière simultanée, et en outre simultanément à une autre opération, notamment un déplacement de la pluralité de plaques.

Plus précisément, l'invention consiste en un procédé mécanique permettant un changement de position d'au moins une plaque de semi-conducteur munie d'au moins un repère de positionnement et placée dans un support destiné à loger une pluralité de plaques de semi-conducteur, caractérisé en ce que qu'il comprend les étapes suivantes :
- pénétrer au moyen d'un bras de préhension dans ledit support avec un premier déplacement dudit bras selon une première direction de l'espace,
- saisir ladite au moins une plaque de semi-conducteur par la partie périphérique de cette dernière avec un deuxième déplacement dudit bras selon une deuxième direction de l'espace,
- orienter ladite au moins une plaque de semi-conducteur saisie, de manière à placer ledit repère de positionnement dans une position déterminée.

La saisie de la plaque de semi-conducteur par sa partie périphérique permet de réduire la contamination de cette plaque, d'éviter la contamination due à la prise par une face de la plaque de semi-conducteur, et l'orientation de la plaque alors que cette dernière a été saisie permet d'effectuer cette opération simultanément à d'autres, notamment un déplacement de la plaque. L'opération d'orientation d'une plaque alors que celle-ci est saisie permet d'éviter l'utilisation d'un poste de traitement spécifique à l'orientation des plaques de semi-conducteur, d'où un gain d'espace pour le traitement des plaques.

Selon une caractéristique avantageuse, le procédé selon l'invention comprend en outre les étapes suivantes :
- retirer ladite au moins une plaque de semi-conducteur hors dudit support avec un troisième déplacement dudit bras de préhension selon ladite première direction, inverse dudit premier déplacement,
- déplacer ladite au moins une plaque de semi-conducteur d'un lieu à un autre dans l'espace à trois directions ou dimensions, avec des déplacements dudit bras choisis parmi les trois directions de l'espace, ladite étape consistant à orienter ladite au moins une plaque de semi-conducteur de manière à placer ledit repère de positionnement dans une position déterminée, ayant lieu simultanément aux déplacements dudit bras de préhension.

Selon une caractéristique avantageuse, le procédé en outre consiste à:
- pénétrer au moyen d'un bras de préhension dans ledit support avec un premier déplacement dudit bras selon une première direction de l'espace,
- saisir une pluralité de plaques de semi-conducteur par la partie périphérique de ces dernières avec un deuxième déplacement dudit bras selon une deuxième direction de l'espace,
- orienter lesdites plaques de semi-conducteur saisies, de manière à aligner lesdits repères de positionnement respectifs desdites plaques de semi-conducteur.

Selon une caractéristique avantageuse, le procédé ci-dessus comprend en outre les étapes suivantes :
- retirer ladite pluralité de plaques de semi-conducteur hors dudit support avec un troisième déplacement dudit bras de préhension selon ladite première direction, inverse dudit premier déplacement,
- déplacer ladite pluralité de plaques de semi-conducteur d'un lieu à un autre dans l'espace à trois directions ou dimensions, avec des déplacements dudit bras choisis parmi les trois directions de l'espace, ladite étape consistant à orienter lesdites plaques de semi-conducteur saisies de manière à aligner leurs repères de positionnement respectifs, ayant lieu simultanément aux déplacements dudit bras de préhension.

L'invention selon la revendication 5 se rapporte également à un dispositif permettant un changement de position d'au moins une plaque de semi-conducteur munie d'au moins un repère de positionnement et placée dans un support destiné à loger une pluralité de plaques de semi-conducteur, ledit dispositif comprenant un bras de préhension de ladite au moins une plaque de semi-conducteur, des moyens de déplacement dudit bras de préhension.

Selon une caractéristique avantageuse, lesdits moyens de préhension comprennent :
- des moyens de prise par la partie périphérique d'une pluralité de plaques de semi-conducteur,
- des moyens d'orientation desdites plaques de semi-conducteur saisies, coopérant avec lesdits moyens de prise afin d'aligner lesdits repères de positionnement respectifs desdites plaques de semi-conducteur.

L'invention se rapporte également à un bras de préhension de semi-conducteur munie d'an moins un repère de positionnement, permettant une saisie d'au moins une plaque de semi-conducteur placée dans un support destiné à loger une pluralité de plaques de semi-conducteur, caractérisé en ce que ledit bras comprend :
- des moyens de prise par la partie périphérique de ladite au moins une plaque de semi-conducteur,
- des moyens d'orientation de ladite au moins une plaque de semi-conducteur coopérant avec lesdits moyens de prise afin de placer ledit repère de positionnement dans une position déterminée,
lesdits moyens de prise et lesdits moyens d'orientation étant disposés sur une structure rigide, lesdits moyens de prise étant répartis sur le périmètre de la partie périphérique de ladite au moins une plaque de semi-conducteur.

Selon une caractéristique avantageuse, lesdits moyens de prise comprennent au moins trois butées dotées respectivement d'un degré de liberté en rotation et réparties sur le périmètre de la partie périphérique de ladite au moins une plaque de semi-conducteur, et lesdits moyens d'orientation comprennent un galet d'entraînement par friction de ladite au moins une plaque de semi-conducteur.

Selon une autre caractéristique avantageuse, ledit galet d'entraînement est constitué par une desdites trois butées qui est rendue au moins partiellement motrice.

Selon une autre caractéristique avantageuse, ledit repère de positionnement est une encoche placée sur la partie périphérique de ladite au moins une plaque de semi-conducteur, et lesdites trois butées comprennent respectivement deux galets entraînés adjacents et libres en rotation.

Selon une autre caractéristique avantageuse, lesdits galets entraînés comportent respectivement an moins une première surface tronconique de contact, pour permettre un appui de ladite au moins une plaque de semi-conducteur par l'intermédiaire d'une arête périphérique de cette dernière.

Selon une autre caractéristique avantageuse, une génératrice de ladite au moins première surface tronconique de contact forme un angle compris entre 5° et 45° avec une perpendiculaire à ladite au moins une plaque de semi-conducteur.

Selon une autre caractéristique avantageuse, lesdits galets entraînés comportent respectivement une deuxième surface tronconique dont le sommet est liée à la base de ladite première surface tronconique, et dont la génératrice forme un angle avec une perpendiculaire à ladite au moins une plaque de semi-conducteur, supérieur à l'angle de la génératrice de ladite première surface tronconique.

Selon une autre caractéristique avantageuse, lesdits moyens d'orientation comprennent un premier faisceau apte à être coupé lorsque ladite encoche n'est pas en face dudit premier faisceau, et un détecteur de coupure dudit premier faisceau.

Selon une autre caractéristique avantageuse, le bras de préhension selon l'invention comprend des moyens de repérage de la position de ladite au moins une plaque de semi-conducteur lorsqu'elle est placée dans ledit support.

Selon une autre caractéristique avantageuse, lesdits moyens de repérage comprennent un deuxième faisceau coopérant avec ledit premier faisceau et une dimension caractéristique de ladite au moins une plaque de semi-conducteur pour permettre d'établir la position de ladite au moins une plaque de semi-conducteur dans ledit support.

Selon une autre caractéristique avantageuse, lesdits moyens de repérage comprennent un troisième faisceau coopérant avec lesdits premier ou deuxième faisceaux et une dimension caractéristique de ladite au moins une plaque de semi-conducteur pour permettre d'établir la position de ladite au moins une plaque de semi-conducteur dans ledit support lorsque ledit premier ou deuxième faisceau est placé en face de ladite encoche.

Selon une autre caractéristique avantageuse, le bras de préhension selon l'invention comprend :
- des moyens de prise par la partie périphérique d'une pluralité de plaques de semi-conducteur,
- des moyens d'orientation desdites plaques de semi-conducteur saisies, coopérant avec lesdits moyens de prise afin d'aligner lesdits repères de positionnement respectifs desdites plaques de semi-conducteur.

L'invention sera mieux comprise et d'autres caractéristiques et avantages apparaîtront à la lecture de la description qui suit des exemples de mode de réalisation de procédés, dispositifs, et bras de préhension selon l'invention, accompagnée des dessins annexés, exemples donnés à titre d'illustration et sans qu'aucune interprétation restrictive de l'invention ne puisse en être tirée.

La figure 1A représente en perspective un exemple de mode de réalisation d'un dispositif selon l'invention, permettant un changement de position d'au moins une plaque de se-conducteur.

La figure 1B représente en perspective un détail agrandi de la figure 1A.

La figure 2 représente en perspective un premier exemple de mode de réalisation d'un bras de préhension selon l'invention.

La figure 3 représente en vue de dessus l'exemple de la figure 2.

La figure 4 représente en vue latérale l'exemple de la figure 2.

La figure 5 représente un premier détail agrandi, en vue latérale, de l'exemple de la figure 2.

La figure 6 représente un deuxième détail agrandi, vue en coupe partielle, de l'exemple de la figure 2.

La figure 7 représente en perspective un deuxième exemple de mode de réalisation d'un bras de préhension selon l'invention.

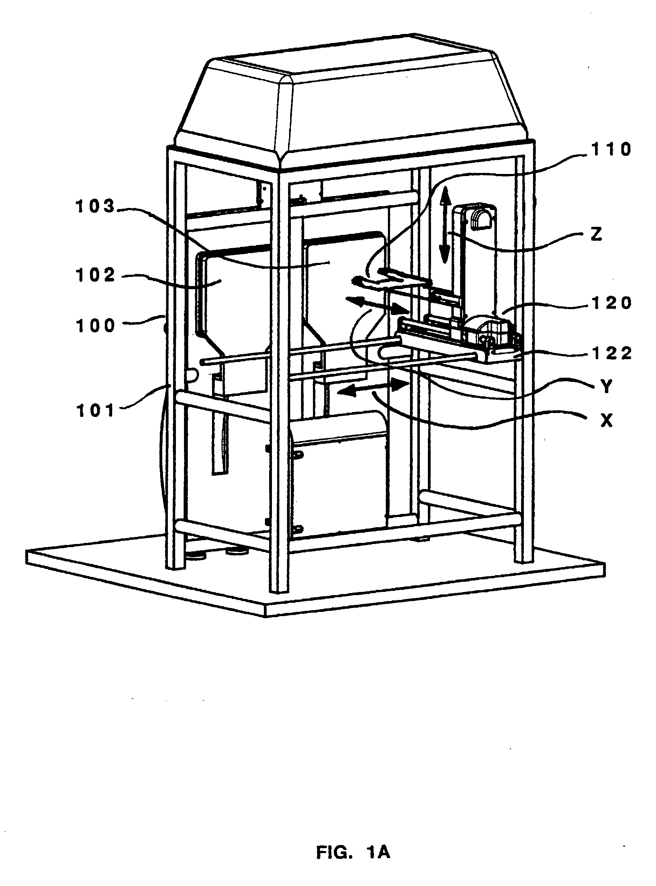

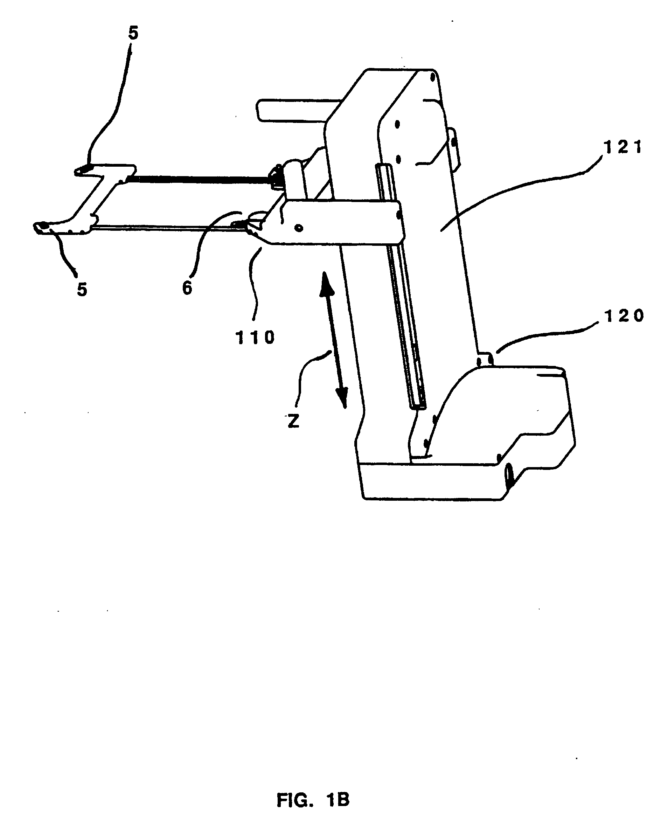

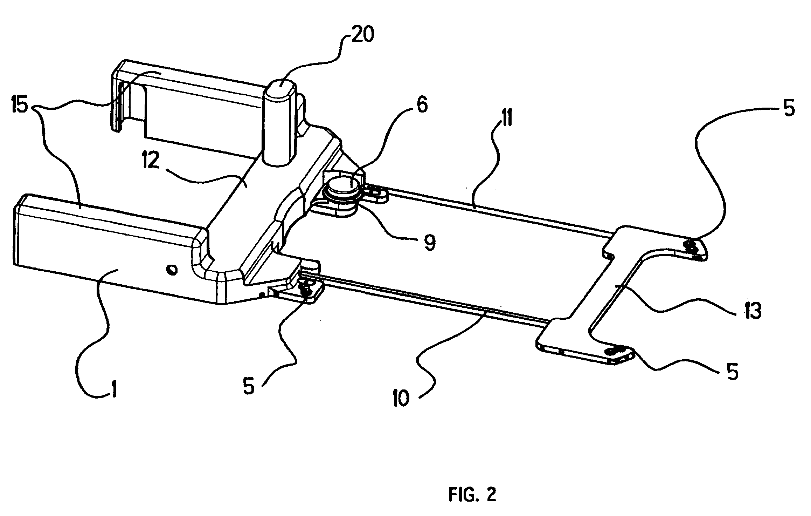

Le dispositif 100 représenté sur les figures 1A, et 1B partiellement, permettant un changement de position des plaques de semi-conducteur munies respectivement d'un repère de positionnement et placées dans un support (non représenté) destiné à loger une pluralité de plaques de semi-conducteur, comprend des moyens de préhension 110 d'une plaque de semi-conducteur, des moyens de déplacement 120 des moyens de préhension 110. Les moyens de préhension 110 seront expliqués en détail plus loin avec l'aide des figures 2 à 6 et comprennent des moyens de prise 5 par la partie périphérique de la plaque de semi-conducteur, des moyens d'orientation 6 de la plaque de semi-conducteur coopérant avec les moyens de prise 5 afin de placer le repère de positionnement dans une position déterminée.

Le dispositif 100 comprend une ossature 101 sur laquelle viennent se fixer deux supports de plaques de semi-conducteur (non représentés). Les deux supports se fixent respectivement sur des platines de réception (non représentées), placées par exemple à côté l'une de l'autre, et à l'aplomb de portes 102 et 103, et présentent des plaques superposées dans des logements respectifs du support, en position horizontale. Le dispositif 100 permet de transférer des plaques de semi-conducteur d'un support à l'autre tout en autorisant un placement des repères respectifs de ces plaques dans une position déterminée. A cet effet, les moyens de préhension 110 sont liés à des moyens de déplacement 120 de manière à être mobiles dans les trois dimensions X, Y, et Z de l'espace, comme représenté sur les figures 1A, et 1B partiellement.

Les moyens de préhension 110, placés en face d'un premier support fixé par exemple à l'aplomb de la porte 103, permettent ainsi de sélectionner la plaque de semi-conducteur à saisir dans ce support, au moyen du déplacement en Z, de pénétrer ensuite dans le support à l'aide du déplacement en Y, de saisir la plaque à l'aide du déplacement en Z vers le haut sans heurter la plaque éventuellement placée au dessus, de retirer la plaque du support à l'aide d'un déplacement inverse en Y, d'utiliser les déplacements en X et Z pour positionner les moyens de préhension 110 en face du deuxième support placé à l'aplomb de la porte 102 et du logement approprié dans ce support pour la plaque saisie. Pendant ces déplacements, la plaque de semi-conducteur sera avantageusement orientée dans une position déterminée, par exemple afin que toutes les plaques de semi-conducteur aient leur repères respectifs alignés. Il est à noter que selon les besoins, le dispositif représenté sur la figure 1A permet d'orienter les plaques dans un support sans les déplacer dans l'autre support ; il suffit pour cela de placer les moyens de préhension 110 en position de saisir une plaque dans son support, c'est à dire placer les moyens 110 sous la plaque à saisir, saisir la plaque à l'aide du déplacement en Z vers le haut sans heurter la plaque éventuellement placée au dessus, et d'orienter la plaque dans la position choisie avant de la déposer à nouveau dans le même logement, puis de retirer les moyens de préhension 110.

La figure 1B montre les moyens de préhension 110 liés à une première partie 121 des moyens de déplacement 120, de manière à permettre un déplacement des moyens de préhension selon un degré de liberté en translation dans la direction Z. Cette première partie 121 des moyens de déplacement est liée avec un degré de liberté en translation selon la direction Y à une deuxième partie 122 des moyens de déplacement 120, elle-même liée avec un degré de liberté en translation selon la direction X à l'ossature 101 du dispositif 100, comme représenté sur la figure 1A.

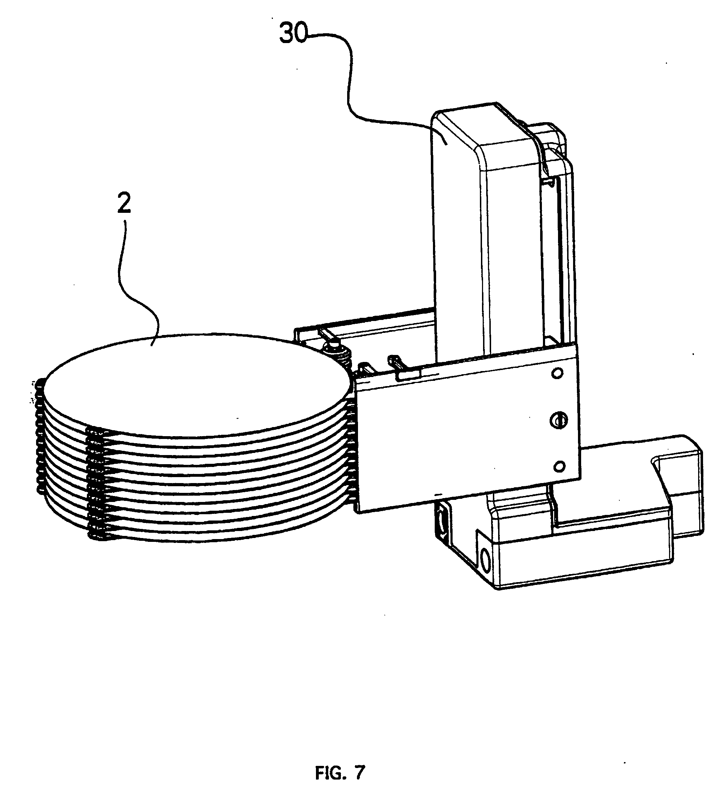

Selon une alternative non représentée, les moyens de préhension peuvent comprendre des moyens de prise par la partie périphérique d'une pluralité de plaques de semi-conducteur, des moyens d'orientation des plaques de semi-conducteur saisies, coopérant avec les moyens de prise afin d'aligner les repères de positionnement respectifs desdites plaques de semi-conducteur. Cette alternative peut être obtenue en remplaçant sur le dispositif 100 représenté, les moyens de préhension 110 par le bras de préhension représenté sur la figure 7 et décrit plus loin.

Il est à noter que le bras de préhension 1 représenté sur les figures 2 à 4 constitue les moyens de préhension 110 du dispositif 100 représenté sur les figures 1A, et 1B partiellement.

Le bras de préhension 1 représenté sur les figures 2 à 4 permet la saisie d'une plaque de semi-conducteur 2, en forme de disque, placée dans un support (non représenté) destiné à loger une pluralité de plaques de semi-conducteur similaires. Les plaques de semi-conducteur 2 sont munies respectivement d'un repère de positionnement 3, se présentant essentiellement sous la forme d'une encoche 3 formée sur la partie périphérique 4 de la plaque 2. On appelle partie périphérique 4 de la plaque de semi-conducteur 2 la surface formée par la tranche de la plaque y compris les deux arêtes d'extrémités de cette surface. Cette surface formée par la tranche peut être par exemple cylindrique ou adopter sensiblement une forme de demi tore circulaire extérieur. La partie périphérique de la plaque pourra comprendre de manière alternative les surfaces annulaires supérieure et inférieure d'extrémités de la plaque, en forme de couronne de faible épaisseur.

Le bras de préhension 1 représenté sur les figures 2 à 4 comprend des moyens de prise 5 par la partie périphérique 4 de la plaque de semi-conducteur 2, des moyens d'orientation 6 de la plaque de semi-conducteur 2 coopérant avec les moyens de prise 5 afin de placer le repère de positionnement 3 dans une position déterminée, comme cela sera expliqué plus loin.

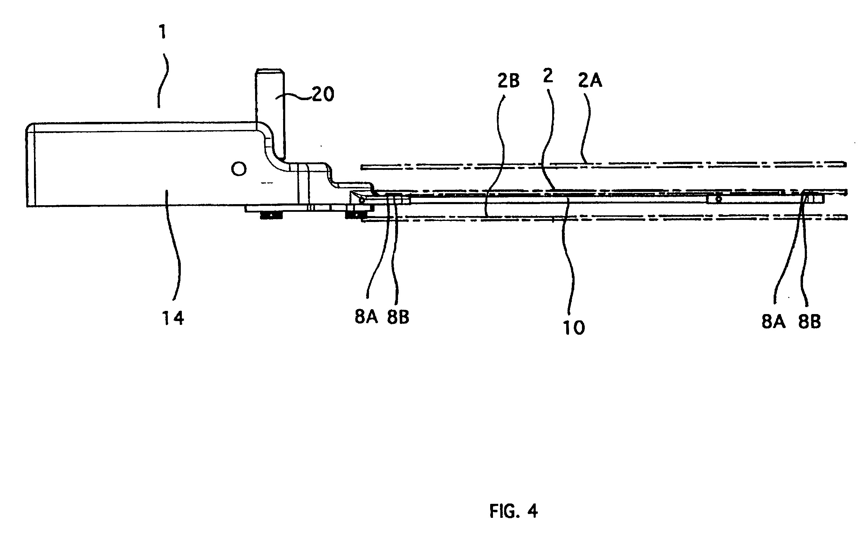

Les moyens de prise 5 et d'orientation 6 sont disposés sur une structure rigide 7 permettant son insertion au moins partielle entre deux plaques successives placées dans un support, par exemple comme représenté sur la figure 4 entre les plaques 2 et 2B représenté en trait mixte. La plaque supérieure 2A en trait mixte représente la plaque de semi-conducteur placée dans le support (non représenté), à ne pas heurter lors de la saisie de la plaque 2. Les moyens de prise comprennent avantageusement trois butées 8 dotées respectivement d'un degré de liberté en rotation et réparties sur le périmètre de la partie périphérique 4 de la plaque 2, et les moyens d'orientation 6 comprennent un galet d'entraînement 9 par friction de la plaque 2.

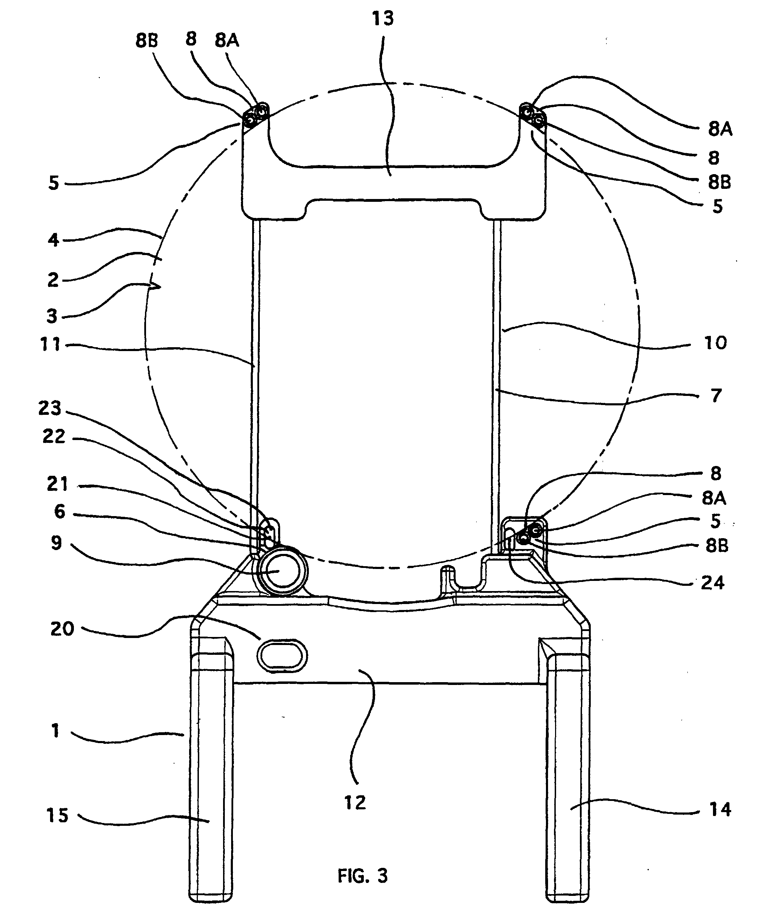

La structure rigide 7 peut par exemple adopter la forme d'un profil en U à la base duquel se trouvent deux des trois butées 8, la troisième butée 8 étant disposée sur une 10 des branches du U, et le galet d'entraînement 9 étant disposé sur l'autre 11 branche du U, comme représenté sur la figure 3. Une barre 12 de renfort peut relier les branches du U à mi-hauteur, comme représenté sur la figure 3. La forme de la structure rigide 7 peut être très variée, celle-ci devant pouvoir être insérée en partie entre deux plaques successives de manière que les moyens de prise 5 puissent saisir une plaque par sa partie périphérique. La structure rigide doit également permettre une orientation de la plaque saisie sans déformation excessive de la partie peu épaisse d'extrémité devant être insérée entre deux plaques. Afin d'obtenir un bras de préhension performant, on choisira une structure 7 offrant une excellente résistance pour un poids minimal. Les branches 10 et 11 du U qui sont destinées à pouvoir pénétrer entre deux plaques successives peuvent avantageusement être constituées d'un matériau métallique, et les parties 12 et 13 de jonction des branches, ainsi que les extrémités 14 et 15 des branches du U ne pénétrant pas entre les plaques de semi-conducteur peuvent être constituées d'un matériau plastique rigide.

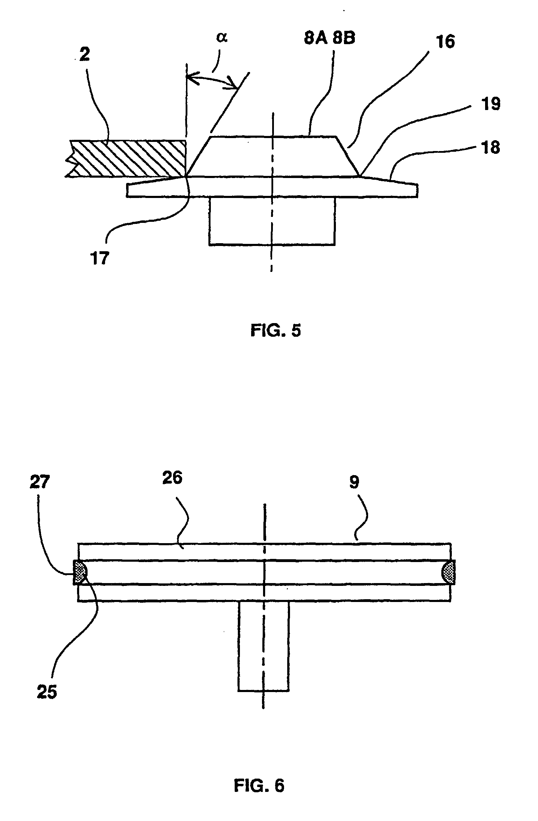

Le galet 9 d'entraînement par friction possède une bande d'entraînement par friction apte à agir sur la partie périphérique de la plaque 2 de semi-conducteur afin d'entraîner cette dernière en déplacement angulaire de préférence par adhérence sur une partie au moins ou la totalité d'une génératrice de la surface constituant la partie périphérique 4 de la plaque 2, pour obtenir un bon coefficient d'adhérence. La bande 27 d'entraînement du galet 9 peut être réalisée par exemple au moyen d'un joint torique 25 en matériau élastique de préférence dur, par exemple d'une dureté shore de l'ordre de 70 à 80, monté sur une roue 26 d'entraînement, comme représenté sur la figure 6. Le joint torique 25 sera de préférence usiné pour présenter une surface d'entraînement cylindrique.

Le galet d'entraînement 9 est entraîné en rotation par un moteur 20 placé sur une partie rigide du bras, par exemple sur la barre 12 de renfort comme représenté sur les figures 2 à 4. La transmission du mouvement de rotation entre le moteur 20 et le galet 9 peut se faire par courroie, engrenages, ou analogue.

Le galet d'entraînement peut, de manière alternative, être constitué par une des trois butées 8 qui serait alors rendue motrice, au moins partiellement. Dans ce cas (non représenté), la butée motrice assure la fonction de permettre un déplacement angulaire de la plaque de semi-conducteur, une rotation dans le cas représenté, et la fonction de participer, en coopération avec les deux autres butées, à la saisie de la plaque de semi-conducteur, et assurer l'équilibre statique de cette dernière. La butée 8 rendue motrice devra présenter une bande d'entraînement appropriée, par exemple comme décrit ci-dessus pour le galet 9 d'entraînement.

Les trois butées 8 comprennent avantageusement et respectivement deux galets 8A et 8B entraînés, adjacents et libres en rotation, comme représenté sur la figure 3. Ceci afin d'éviter que l'encoche 3 constituant le repère de positionnement de la plaque 2 ne perturbe la motricité du galet d'entraînement ou l'équilibre statique de la plaque lorsque l'encoche 3 passe au niveau d'une butée 8 lors d'une rotation de la plaque, ou lorsque l'encoche se trouve en face d'une butée 8 lors de la saisie de la plaque dans le support (non représenté). Les galets entraînés sont positionnés de manière que leurs surfaces respectives de contact avec la plaque 2 soient tangentes à la surface de tranche de la plaque. Ainsi, si l'encoche 3 se trouve en face de l'une des trois butées 8A ou 8B, la butée adjacente 8B ou 8A respectivement, assurera l'équilibre statique et dynamique de la plaque. Dans le cas évoqué plus haut d'une des butées 8 rendue motrice, un seul des galets 8A ou 8B serait rendue moteur, l'autre étant entraîné.

Sur l'exemple représenté, les axes de rotation des galets entraînés 8A et 8B et du galet d'entraînement 9 sont perpendiculaires au plan horizontal défini par la plaque de semi-conducteur 2. On peut toutefois envisager des axes ayant une autre direction, en fonction du profil de contact des galets sur la plaque, de manière que ces derniers n'entrent pas en contact avec l'une ou l'autre des faces de la plaque de semi-conducteur.

Un galet entraîné 8A ou 8B, comme représenté sur la figure 5, comporte avantageusement une première surface tronconique 16 de contact, pour permettre un contact de la plaque 2 de semi-conducteur par l'intermédiaire d'une arête périphérique 17 de cette dernière. Sur la figure 5, le galet 8A ou 8B est représenté en vue latérale, et il est prévu pour saisir une plaque placée de manière sensiblement ou exactement horizontale. De manière avantageuse, une génératrice de la première 16 surface tronconique de contact forme un angle α compris entre 5° et 45° avec une perpendiculaire à la plaque 2 de semi-conducteur. De manière avantageuse, un galet 8A ou 8B entraîné comporte une deuxième 18 surface tronconique dont le sommet 19 est liée à la base de la première 16 surface tronconique, et dont la génératrice forme un angle avec une perpendiculaire à la plaque 2 de semi-conducteur, supérieur à l'angle α de la génératrice de la première 16 surface tronconique. De manière alternative, le sommet 19 de la deuxième surface tronconique 18 de chaque butée 8A, 8B pourra présenter une surface plane annulaire horizontale (non représentée) adoptant la forme d'une couronne d'épaisseur radiale faible permettant à la plaque de reposer sur l'extrémité annulaire de sa surface inférieure.

Il est à noter que d'autres types de surface de révolution pourront être adoptés en remplacement des surfaces tronconiques 16 et 18 décrites, par exemple des première et deuxième surfaces de révolution formées par une génératrice courbe donnant lieu à des surfaces concaves, convexes, ou autres par exemple.

La hauteur de la première 16 surface tronconique de contact sera définie en accord avec, la hauteur disponible entre deux plaques successives, l'inclinaison selon l'angle α de la génératrice de la surface 16 et la précision de la position relative du bras de préhension par rapport à une plaque avant sa saisie, de manière que la plaque saisie se trouve en appui de préférence sur les premières 16 surfaces tronconiques, ou sur les premières et deuxièmes 18 surfaces tronconiques des galets entraînés 8A et 8B. Par exemple, pour une hauteur donnée de la première 16 surface tronconique, fonction de l'espace disponible entre deux plaques successives sur le support des plaques, la longueur de la projection horizontale de la génératrice de la première surface tronconique devra être supérieure ou égale à l'erreur radiale possible de position du bras par rapport à la plaque de semi-conducteur.

Les galets entraînés 8A et 8B seront de préférence réalisés dans un matériau plastique rigide et adopteront une faible inertie en rotation afin d'être entraînés en rotation aisément par friction par la plaque de semi-conducteur. Les galets 8A et 8B seront à cet effet de préférence montés sur la structure 7 par l'intermédiaire de roulements (non représentés).

Il est à noter que les galets entraînés 8A et 8B représentés sur les figures 2 à 5 sont prévus pour permettre la saisie d'une plaque disposée de manière horizontale, comme cela a été dit ci-dessus. Il peut également être envisagé de saisir une plaque placée dans une autre position, par exemple verticale. Dans ce cas, les galets devront comporter des moyens permettant d'éviter que la plaque ne se libère des moyens de prises sous l'effet de la gravité ou du déplacement du bras de préhension, par exemple une troisième surface tronconique (non représentée) symétrique de la deuxième surface tronconique par rapport au plan de la plaque, une des trois butées 8 étant alors par exemple montée mobile sur la structure rigide 7 afin de permettre à la plaque un franchissement de la troisième surface tronconique et un rapprochement de la butée mobile jusqu'au contact avec la tranche de la plaque pour ne laisser à cette dernière qu'un degré de liberté en rotation.

Les moyens d'orientation 6 du bras de préhension représenté sur les figures 2 à 4 comprennent avantageusement un premier faisceau 21 apte à être coupé lorsque l'encoche 3 de la plaque 2 n'est pas en face du faisceau 21, et un détecteur 23 de coupure du premier faisceau 21. Le faisceau 21 peut par exemple être un faisceau lumineux de préférence vertical émis par une diode électroluminescente 22 et 1e détecteur être une cellule photosensible 23 placée en face de la diode émettrice. Le faisceau 21 sera placé de telle sorte que lors d'un déplacement angulaire de la plaque 2 sous l'effet du galet d'entraînement 9, l'encoche 3 puisse laisser traverser le faisceau 21 jusqu'à la cellule photosensible 23, le faisceau 21 étant dans le cas contraire coupé par la plaque 2. Lorsque la position de l'encoche 3 a été repérée par la réception du faisceau 21 sur la cellule photosensible 23, la plaque 2 est orientée par le galet moteur 9 de la valeur angulaire désirée afin de placer le repère 3 dans une position déterminée. Le fonctionnement du galet 9 et de la cellule photosensible 23 au moins sera avantageusement commandé et contrôlé par une unité centrale (non représentée) avantageusement automatisée en fonction des opérations à réaliser.

Le bras de préhension représenté sur les figures 2 à 4 comprend avantageusement des moyens de repérage 21, 24 de la position de la plaque 2 de semi-conducteur lorsqu'elle est placée dans un support (non représenté). Les moyens de repérage ont pour fonction de permettre un positionnement optimal du bras de préhension avant de saisir une plaque 2 de semi-conducteur. Le repérage consiste à localiser deux points quelconques de la partie périphérique 4 d'une plaque 2 à saisir, par exemple par l'intermédiaire de deux faisceaux 21 et 24 placés sur la structure 7 du bras, et définissant respectivement les deux points sur un plan horizontal, comme représenté sur la figure 3 dans le plan de la feuille. Le faisceau 24 peut par exemple être un faisceau lumineux émis par une diode électroluminescente et le détecteur être une cellule photosensible placée en face de la diode émettrice. Les moyens de repérage comprennent avantageusement le premier 21 et le deuxième faisceau 24 vertical coopérant avec le premier faisceau et une dimension caractéristique de la plaque 2 de semi-conducteur, en l'exemple le diamètre extérieur de la plaque, pour permettre d'établir la position de la plaque de semi-conducteur dans le support (non représenté), dans un plan horizontal.

Les deux points de la partie périphérique 4 de la plaque 2 sont localisés lors de petits déplacements d'approche du bras comportant les faisceaux 21 et 24 en vue d'un positionnement approprié pour une saisie de la plaque. Les deux faisceaux 21 et 24 distincts permettent de localiser la corde d'un arc de la partie périphérique circulaire de la plaque 2, dès que les faisceaux sont coupés par la partie périphérique de la plaque, corde qui combinée à la connaissance du diamètre de cette partie circulaire de la plaque permet de déterminer la position de la plaque et de placer le bras dans une position relative appropriée en vue d'une saisie de la plaque entre les butées 8 comme expliqué plus haut.

Il est à noter que le premier faisceau 21, utilisé dans le cadre des moyens d'orientation de la plaque, est également avantageusement utilisé dans le cadre des moyens de repérage afin de simplifier le bras de préhension. Il est bien sûr possible d'utiliser de manière alternative deux faisceaux distincts pour les moyens d'orientation et de repérage, respectivement.

De manière alternative et avantageuse, les moyens de repérage comprennent un troisième faisceau (non représenté) coopérant avec le premier 21 ou deuxième 24 faisceau et une dimension caractéristique de la plaque de semi-conducteur, son diamètre extérieur dans l'exemple, pour permettre d'établir la position de la plaque de semi-conducteur dans son support lorsque le premier ou deuxième faisceau est placé en face de l'encoche servant de repère de positionnement. A cet effet, le troisième faisceau sera placé en tout endroit permettant d'obtenir la corde d'un arc de la partie périphérique de la plaque, en combinaison avec celui des premier ou deuxième faisceau qui n'est pas placé en face de l'encoche, et de retrouver la configuration de deux points d'une corde d'arc de la partie périphérique de la plaque. En effet, l'encoche pénètre en général dans la plaque selon une longueur non négligeable et pourrait entraîner de ce fait une mesure erronée de l'arc, et donc de la position de la plaque. Le troisième faisceau permet de s'assurer que deux faisceaux au moins ne seront pas en face de l'encoche, pour obtenir une corde. Le troisième faisceau peut être réalisé de manière similaire aux deux premiers.

Le fonctionnement du bras de préhension représenté sur les figures 2 à 4 est le suivant : le bras est introduit dans un support contenant des plaques de semi-conducteur dont on veut modifier la position, par exemple comme décrit plus haut à l'aide des figures 1A et 1B. L'approche du bras sous une plaque se fait avec l'aide des moyens de repérage comme décrit également plus haut de manière que le bras soit placé dans une position telle qu'un déplacement vers le haut de celui-ci entraîne la saisie de la plaque entre les galets 8A et 8B du bras. La plaque doit, lors de la saisie, reposer au moins sur les premières surfaces tronconiques 16 d'une partie des galets 8A, 8B de manière que celle-ci se centre d'elle-même par gravité ou dès sa mise en mouvement angulaire par le galet d'entraînement, sensiblement ou exactement au sommet 19 de la deuxième surface tronconique 18 de chaque galet entraîné. Ainsi, la plaque repose de préférence sur les butées 8A et 8B par son arête périphérique inférieure 17, comme représenté sur la figure 5. La plaque est ensuite mise en mouvement angulaire par le galet d'entraînement 9 jusqu'à ce que l'encoche 3 passe sur le faisceau 21 permettant à la cellule photosensible 23 d'être actionnée et permettant ainsi un repérage de la position angulaire de la plaque dont la rotation est ensuite effectuée par rapport à cette position afin de placer la plaque dans la position déterminée. Lors de la rotation de la plaque, celle-ci est en appui sur les premières surfaces tronconiques 16 d'une partie des galets 8A, 8B. Lorsque la position désirée est atteinte, la plaque est reposée dans le support comme décrit plus haut.

Le bras de préhension représenté sur la figure 7 comprend des moyens de prise par la partie périphérique d'une pluralité de plaques 2 de semi-conducteur, des moyens d'orientation des plaques de semi-conducteur saisies, coopérant avec les moyens de prise afin d'aligner les repères de positionnement respectifs des plaques de semi-conducteur saisies par le bras. Les moyens de prise comprennent une pluralité de structures 7 partielles, aptes à être insérées respectivement dans les espaces libres entre plaques de semi-conducteur d'un support (non représenté), et reliées par un support rigide 30 commun, comme représenté. Chaque structure porte un galet d'entraînement en rotation de la plaque qu'elle est destinée à soutenir, trois butées 8 d'appui de cette plaque, et deux faisceaux 21 et 24, comme décrit précédemment pour une structure 7. Le bras représenté sur la figure 7 permet de saisir avantageusement simultanément une pluralité de plaques 2 placées dans un support, et d'orienter avantageusement simultanément ces plaques de manière à les placer dans une position déterminée, par exemple de manière à aligner leurs encoches 3. Ainsi, l'alignement des encoches peut se faire par exemple pendant un transfert des plaques d'un lieu à un autre.

Plusieurs exemples de procédés selon l'invention vont maintenant être décrits. Un premier exemple procédé selon l'invention consiste en un procédé mécanique permettant un changement de position d'une ou plusieurs plaques de semi-conducteur munie d'une encoche et placée dans un support destiné à loger une pluralité de plaques de semi-conducteur, consistant à saisir la ou les plaques de semi-conducteur par la partie périphérique de celles-ci, orienter la ou les plaques de semi-conducteur afin de placer leur(s) encoche(s) dans une position déterminée. Un tel procédé peut, par exemple, être mis en oeuvre par un dispositif selon l'invention tel que décrit plus haut, permettant notamment un alignement des encoches des plaques de semi-conducteur placées dans un support sans retirer ces plaques de leur support.

Un deuxième exemple de procédé selon l'invention consiste à déplacer d'un lieu à un autre la ou les plaques de semi-conducteur et orienter simultanément celles-ci de manière à placer leurs encoches dans une position déterminée, par exemple de manière à aligner les encoches. Un tel procédé peut par exemple être mis en oeuvre par un dispositif de transfert de plaques tel que décrit plus haut.

## Revendications

1. Procédé mécanique permettant un changement de position d'au moins une plaque de semi-conducteur (2) munie d'au moins un repère de positionnement (3) et placée dans un support comportant une pluralité de logements superposés dans une première direction (Z) perpendiculaire à la surface de la plaque, ledit procédé comprenant les étapes suivantes :
a) pénétrer au moyen d'un seul bras de préhension (1) dans ledit logement avec un premier déplacement dudit bras selon une deuxième direction (Y) de l'espace parallèle à la surface de la plaque,
b) saisir ladite au moins une plaque de semi-conducteur par la partie périphérique (4) de cette dernière avec un deuxième déplacement dudit bras selon la première direction (Z) de l'espace, et
c) orienter au moyen dudit bras ladite au moins une plaque de semi-conducteur ainsi saisie, de manière à placer ledit repère de positionnement dans une position déterminée.

2. Procédé selon la revendication 1, ***caractérisé en ce qu***'il comprend en outre les étapes suivantes :
d) retirer ladite au moins une plaque de semi-conducteur hors dudit logement avec un troisième déplacement dudit bras de préhension (1) selon ladite seconde direction (Y), inverse dudit premier déplacement,
e) déplacer ladite au moins une plaque de semi-conducteur (2) d'un lieu à un autre dans l'espace à trois directions ou dimensions (X, Y, Z) avec des déplacements dudit bras choisis parmi les trois directions (X, Y, Z) de l'espace, ladite étape (c) consistant à orienter ladite au moins une plaque de semi-conducteur de manière à placer ledit repère de positionnement (3) dans une position déterminée, ayant lieu simultanément aux déplacements dudit bras de préhension.

3. Procédé mécanique selon la revendication 1, permettant un changement de position d'une pluralité de plaques de semi-conducteur (2) munies chacune d'au moins un repère de positionnement (3) et placées chacune dans un support comportant une pluralité de logements superposés dans une première direction (Z) perpendiculaire à la surface des plaques,
***caractérisé en ce qu***'il comprend les étapes suivantes :
i) pénétrer au moyen d'un bras de préhension simultanément dans lesdits logements du support avec un premier déplacement dudit bras selon la seconde direction (Y) de l'espace,
ii) saisir simultanément une pluralité de plaques de semi-conducteur par la partie pédiphérique (4) de ces dernières avec un deuxième déplacement dudit bras selon la première direction (Z) de l'espace, et
iii) orienter lesdites plaques de semi-conducteur ainsi simultanément saisies, de manière à aligner lesdits repères de positionnement respectifs desdites plaques de semi-conducteur.

4. Procédé selon la revendication 3, ***caractérisé en ce qu***'il comprend en outre les étapes suivantes :
iv) retirer ladite pluralité de plaques de semi-conducteur (2) hors des logements respectifs dudit support avec un troisième déplacement dudit bras de préhension selon ladite seconde direction (Y), inverse dudit premier déplacement, et
v) déplacer ladite pluralité de plaques de semi-conducteur d'un lieu à l'autre dans l'espace à trois directions ou dimensions (X, Y, Z), avec des déplacements dudit bras choisis parmi les trois directions (X, Y, Z) de l'espace, ladite étape iii) consistant à orienter lesdites plaques de semi-conducteur saisies de manière à aligner leurs repères de positionnement respectifs, ayant lieu simultanément aux déplacements dudit bras de préhension.

5. Dispositif permettant un changement de position d'au moins une plaque de semi-conducteur (2) munie d'au moins un repère de positionnement (3) et placée dans un support comportant une pluralité de logements superposés dans une première direction (Z) perpendiculaire à la surface de la plaque, ledit dispositif comprenant un seul bras de préhension et des moyens de déplacement dudit bras de préhension,
lesdits moyens de déplacement comprenant :
- une deuxième partie (122) permettant au dit bras de préhension de pénétrer dans ledit logement avec un premier déplacement dudit bras selon une deuxième direction (Y) de l'espace parallèle à la surface de la plaque,
- une première partie (121) permettant au dit bras de préhension (1) un déplacement selon la première direction (Z) de l'espace afin de saisir ladite au moins une plaque de semi-conducteur par la partie périphérique de cette dernière,
- des moyens permettant au dit bras de préhension (1) un déplacement suivant une troisième direction (X) de l'espace,
***caractérisé en ce que*** ledit bras de préhension comprend :
- des moyens de prise par la partie périphérique de ladite au moins une plaque de semi-conducteur comprenant au moins trois butées (8) dotées respectivement d'un degré de liberté en rotation et réparties sur le périmètre de la partie périphérique (4) de ladite au moins une plaque de semi-conducteur (2),
- des moyens d'orientation de ladite au moins une plaque de semi-conducteur, coopérant avec lesdits moyens de prise en vue de placer ledit repère de positionnement dans une position déterminée, lesdits moyens d'orientation comprenant un galet d'entraînement (9) par friction de ladite au moins une plaque de semi-conducteur, et
lesdits moyens de prise (5) et lesdits moyens d'orientation (6) étant disposés sur une structure rigide (7) du bras.

6. Dispositif selon la revendication 5, ***caractérisé en ce que*** ledit bras de préhension comprend des moyens de prise par la partie périphérique d'une pluralité de plaques de semi-conducteur (2), et des moyens d'orientation desdites plaques de semi-conducteur saisies, coopérant avec lesdits moyens de prise en vue d'aligner lesdits repères de positionnement respectifs desdites plaques de semi-conducteur.

7. Dispositif selon la revendication 5, ***caractérisé en ce que*** ledit galet d'entraînement (9) est constitué par une desdites trois butées (8) qui est rendue au moins partiellement motrice.

8. Dispositif selon la revendication 5 ou la revendication 7, ***caractérisé en ce que*** ledit repère de positionnement est une encoche (3) placée sur la partie périphérique (4) de ladite au moins une plaque de semi-conducteur (2), et **en ce que** lesdites trois butées (8) comprennent respectivement deux galets entraînés (8A, 8B) adjacents et libres en rotation.

9. Dispositif selon la revendication 8, ***caractérisé en ce que*** lesdits galets entraînés (8) comportent respectivement au moins une première surface tronconique (16) de contact, en vue d'un appui de ladite au moins une plaque de semi-conducteur (2) par l'intermédiaire d'une arête périphérique (17) de cette dernière.

10. Dispositif selon la revendication 9, ***caractérisé en ce qu***'une génératrice de ladite au moins première surface tronconique de contact forme un angle (α) compris entre 5° et 45° avec une perpendiculaire à ladite au moins une plaque de semi-conducteur (2).

11. Dispositif selon la revendication 10, ***caractérisé en ce que*** lesdits galets entraînés (8) comportent respectivement une deuxième (18) surface tronconique dont le sommet (19) est liée à la base de ladite première (16) surface tronconique, et dont la génératrice forme un angle avec une perpendiculaire à ladite au moins une plaque de semi-conducteur (2), supérieur à l'angle (α) de la génératrice de ladite première surface tronconique.

12. Dispositif selon l'une quelconque des revendications 8 à 11, ***caractérisé en ce que*** lesdits moyens d'orientation (6) comprennent un premier faisceau lumineux (21) apte à être coupé lorsque ladite encoche (3) n'est pas en face dudit premier faisceau, et un détecteur (23) de coupure dudit premier faisceau.

13. Dispositif selon l'une quelconque des revendications 6 à 12, ***caractérisé en ce qu***'il comprend des moyens de repérage (21, 24) de la position de ladite au moins une plaque de semi-conducteur (2) lorsqu'elle est placée dans ledit support.

14. Dispositif selon les revendications 12 à 13, ***caractérisé en ce que*** lesdits moyens de repérage comprennent un deuxième (24) faisceau lumineux coopérant avec ledit premier faisceau (21) et une dimension caractéristique de ladite au moins une plaque de semi-conducteur (2) en vue d'établir la position de ladite au moins une plaque de semi-conducteur dans ledit support.

15. Dispositif selon la revendication *14,* ***caractérisé en ce que*** lesdits moyens de repérage (21, 24) comprennent un troisième faisceau lumineux coopérant avec lesdits premier (21) ou deuxième (24) faisceaux lumineux et une dimension caractéristique de ladite au moins une plaque de semi-conducteur (2) en vue d'établir la position de ladite au moins une plaque de semi-conducteur dans ledit support lorsque ledit premier ou deuxième faisceau est placé en face de ladite encoche (3).

## Patentansprüche

1. Mechanisches Verfahren, das eine Änderung der Position mindestens einer Halbleiterplatte (2) erlaubt, die mindestens eine Positionierungsmarke (3) aufweist und in einer Halterung angeordnet ist, die eine Vielzahl von Aufnahmen aufweist, die in einer ersten Richtung (Z) senkrecht zur Oberfläche der Platte übereinander angeordnet sind, wobei das Verfahren die folgenden Schritte aufweist:
a) Eindringen mittels eines einzigen Greifarms (1) in die Aufnahme mit einer ersten Bewegung des Arms in eine zweite Raumrichtung (Y) parallel zur Oberfläche der Platte,
b) Greifen der mindestens einen Halbleiterplatte an dem Umfangsabschnitt (4) von letzterer mit einer zweiten Bewegung des Arms in die erste Raumrichtung (Z) und
c) Orientieren der so gegriffenen zumindest einen Halbleiterplatte mittels des Armes derart, dass die Positionierungsmarke in eine bestimmte Position gebracht wird.

2. Verfahren nach Anspruch 1,
**dadurch gekennzeichnet,**
**dass** es überdies die folgenden Schritte aufweist:
d) Zurückziehen der mindestens einen Halbleiterplatte aus der Aufnahme heraus mit einer dritten Bewegung des Greifarms (1) in die zweite Richtung (Y), der ersten Bewegung entgegengerichtet,
e) Bewegen der mindestens einen Halbleiterplatte (2) von einem Ort zu einem anderen im Raum mit drei Richtungen oder Dimensionen (X, Y, Z) mit Bewegungen des Arms, die unter den drei Raumrichtungen (X, Y, Z) ausgewählt werden, wobei der Schritt (c), der darin besteht, die mindestens eine Halbleiterplatte zu orientieren, um die Positionierungsmarke (3) in eine bestimmte Position zu bringen, gleichzeitig mit den Bewegungen des Greifarms stattfindet.

3. Mechanisches Verfahren nach Anspruch 1,
das eine Änderung der Position einer Vielzahl von Halbleiterplatten (2) erlaubt, die alle mindestens eine Positionierungsmarke (3) aufweisen und alle in einer Halterung angeordnet sind, die eine Vielzahl von Aufnahmen aufweist, die in einer ersten Richtung (Z) senkrecht zur Oberfläche der Platten übereinander angeordnet sind,
**dadurch gekennzeichnet,**
**dass** es die folgenden Schritte aufweist:
i) Gleichzeitiges Eindringen mittels eines Greifarms in die Aufnahmen der Halterung mit einer ersten Bewegung des Arms in die zweite Raumrichtung (Y),
ii) gleichzeitiges Greifen einer Vielzahl von Halbleiterplatten an dem Umfangsabschnitt (4) von Letzteren mit einer zweiten Bewegung des Armes in die erste Raumrichtung (Z), und
iii) Orientieren der so gleichzeitig gegriffenen Halbleiterplatten, um die jeweiligen Positionierungsmarken der Halbleiterplatten auszurichten.

4. Verfahren nach Anspruch 3,
**dadurch gekennzeichnet,**
**dass** es überdies die folgenden Schritte aufweist:
iv) Zurückziehen der Vielzahl von Halbleiterplatten (2) aus den jeweiligen Aufnahmen der Halterung heraus mit einer dritten Bewegung des Greifarms in die zweite Richtung (Y), der ersten Bewegung entgegengerichtet, und
v) Bewegen der Vielzahl von Halbleiterplatten von einem Ort zum anderen im Raum mit drei Richtungen oder Dimensionen (X, Y, Z) mit Bewegungen des Armes, die unter den drei Raumrichtungen (X, Y, Z) ausgewählt werden, wobei der Schritt iii), der darin besteht, die gegriffenen Halbleiterplatten zu orientieren, um ihre jeweiligen Positionierungsmarken auszurichten, gleichzeitig mit den Bewegungen des Greifarms stattfindet.

5. Vorrichtung, die eine Änderung der Position mindestens einer Halbleiterplatte (2) erlaubt, die mindestens eine Positionierungsmarke (3) aufweist und in einer Halterung angeordnet ist, die eine Vielzahl von Aufnahmen aufweist, die in einer ersten Richtung (Z) senkrecht zur Oberfläche der Platte übereinander angeordnet sind, wobei die Vorrichtung einen einzigen Greifarm sowie Mittel zum Bewegen des Greifarms aufweist,
wobei die Mittel zum Bewegen aufweisen:
- ein zweites Teil (122), das es dem Greifarm erlaubt, mit einer ersten Bewegung des Armes in eine zweite Raumrichtung (Y), parallel zur Oberfläche der Platte, in die Aufnahme einzugreifen,
- ein erstes Teil (121), das dem Greifarm (1) eine Bewegung in die erste Raumrichtung (Z) erlaubt, um die mindestens eine Halbleiterplatte am Umfangsabschnitt von Letzterer zu greifen,
- Mittel, die dem Greifarm (1) eine Bewegung entlang einer dritten Raumrichtung (X) erlauben,
**dadurch gekennzeichnet,**
**dass** der Greifarm aufweist:
- Mittel zum Ergreifen der mindestens einen Halbleiterplatte am Umfangsabschnitt, die mindestens drei Anschläge (8) aufweisen, die jeweils mit einem Rotationsfreiheitsgrad versehen sind und am Umfang des Umfangsabschnittes (4) der mindestens einen Halbleiterplatte (2) verteilt sind,
- Mittel zum Orientieren der mindestens einen Halbleiterplatte, die mit den Mitteln zum Ergreifen zusammenwirken, um die Positionierungsmarke in eine bestimmte Position zu bringen, wobei die Mittel zum Orientieren eine Reibungsantriebsrolle (9) der mindestens einen Halbleiterplatte aufweisen, und die Mittel (5) zum Ergreifen und die Mittel (6) zum Orientieren auf einer starren Struktur (7) des Armes angeordnet sind.

6. Vorrichtung nach Anspruch 5,
**dadurch gekennzeichnet,**
**dass** der Greifarm Mittel zum Ergreifen einer Vielzahl von Halbleiterplatten (2) an dem Umfangsabschnitt aufweist sowie Mittel zum Orientieren der gegriffenen Halbleiterplatten, die mit den Mitteln zum Ergreifen zusammenwirken, um die jeweiligen Positionierungsmarken der Halbleiterplatten anzuordnen.

7. Vorrichtung nach Anspruch 5,
**dadurch gekennzeichnet,**
**dass** die Antriebsrolle (9) mindestens einen der drei Anschläge (8) aufweist, der zumindest partiell angetrieben ausgebildet ist.

8. Vorrichtung nach Anspruch 5 oder 7,
**dadurch gekennzeichnet,**
**dass** die Positionierungsmarke eine Kerbe (3) ist, die an dem Umfangsabschnitt (4) der mindestens einen Halbleiterplatte (2) angeordnet ist, und dass die drei Anschläge (8) jeweils zwei benachbarte und drehbare Antriebsrollen (8A, 8B) aufweisen.

9. Vorrichtung nach Anspruch 8,
**dadurch gekennzeichnet,**
**dass** die Antriebsrollen (8) jeweils mindestens eine erste kegelstumpfartige Kontaktoberfläche (16) aufweisen zum Halten der mindestens einen Halbleiterplatte (2) über eine Umfangskante (17) der Letzteren.

10. Vorrichtung nach Anspruch 9,
**dadurch gekennzeichnet,**
**dass** eine Erzeugende der mindestens einen ersten kegelstumpfartigen Kontaktoberfläche einen Winkel (α) zwischen 5° und 45° mit einer Senkrechten zur mindestens einen Halbleiterplatte (2) bildet.

11. Vorrichtung nach Anspruch 10,
**dadurch gekennzeichnet,**
**dass** die Antriebsrollen (8) jeweils eine zweite kegelstumpfartige Oberfläche (18) aufweisen, deren Scheitel (19) mit der Basis der ersten kegelstumpfartigen Oberfläche (16) verbunden ist und deren Erzeugende einen Winkel mit einer Senkrechten zur mindestens einen Halbleiterplatte (2) bildet, der größer ist als der Winkel (α) der Erzeugenden der ersten kegelstumpfartigen Oberfläche.

12. Vorrichtung nach einem der Ansprüche 8 bis 11,
**dadurch gekennzeichnet,**
**dass** die Mittel (6) zur Orientierung ein erstes Lichtbündel (21) aufweisen, das dazu ausgelegt ist, unterbrochen zu werden, wenn die Kerbe (3) dem ersten Lichtbündel nicht gegenüberliegt, sowie einen Detektor (23) für die Unterbrechung des ersten Lichtbündels.

13. Vorrichtung nach einem der Ansprüche 6 bis 12,
**dadurch gekennzeichnet,**
**dass** sie Mittel (21, 24) zum Erkennen der Position der mindestens einen Halbleiterplatte (2), wenn sie in der Halterung angeordnet wird, aufweist.

14. Vorrichtung nach den Ansprüchen 12 bis 13,
**dadurch gekennzeichnet,**
**dass** die Mittel zum Erkennen ein zweites Lichtbündel (24) aufweisen, das mit dem ersten Lichtbündel (21) zusammenarbeitet, sowie eine charakteristische Abmessung der mindestens einen Halbleiterplatte (2), um die Position der mindestens einen Halbleiterplatte in der Halterung zu ermitteln.

15. Vorrichtung nach Anspruch 14,
**dadurch gekennzeichnet,**
**dass** die Mittel (21, 24) zum Erkennen ein drittes Lichtbündel aufweisen, das mit dem ersten Lichtbündel (21) oder zweiten Lichtbündel (24) zusammenwirkt, sowie eine charakteristische Abmessung der mindestens einen Halbleiterplatte (2), um die Position der mindestens einen Halbleiterplatte in der Halterung festzustellen, wenn das erste oder das zweite Lichtbündel der Kerbe (3) gegenüberliegt.

## Claims

1. Mechanical method permitting a change in position of at least one semiconductor wafer (2) provided with at least one positioning mark (3) and placed in a support comprising a plurality of housings superposed in a first direction (Z) perpendicular to the surface of the wafer, said method comprising the following steps:
a) penetrating at least one single gripping arm (1) in said housing with a first displacement of said arm in a second spatial direction (Y) parallel to the surface of the wafer,
b) gripping said at least one semiconductor wafer by the peripheral part (4) of the latter with a second displacement of said arm in the first spatial direction (Z), and
c) orientating at least said arm of said at least one thus gripped semiconductor wafer so as to place said positioning mark in a defined position.

2. Method according to claim 1, **characterised in that** it also comprises the following steps:
d) withdrawing said at least one semiconductor wafer from said housing with a third displacement of said gripping arm (1) in said second direction (Y), opposite said first displacement,
e) displacing said at least one semiconductor wafer (2) from one place to another in space with three directions or dimensions (X, Y, Z), with displacements of said arm selected from the three spatial directions (X, Y, Z), said step (c) comprising orientating said at least one semiconductor wafer so as to place said positioning mark (3) in a defined position, this occurring simultaneously with the displacements of said gripping arm.

3. Mechanical method according to claim 1, permitting a change in position of a plurality of semiconductor wafers (2) each provided with at least one positioning mark (3) and each placed in a support comprising a plurality of housings superposed in a first direction (Z) perpendicular to the surface of the wafers, **characterised in that** it comprises the following steps:
i) penetrating, by means of one gripping arm, simultaneously said housings of the support with a first displacement of said arm in the second spatial direction (Y),
ii) gripping simultaneously a plurality of semiconductor wafers by the peripheral part (4) of said wafers with a second displacement of said arm in the first spatial direction (Z), and
iii) orientating said thus simultaneously gripped semiconductor wafers so as to align said respective positioning marks of said semiconductor wafers.

4. Method according to claim 3, **characterised in that** it also comprises the following steps:
iv) withdrawing said plurality of semiconductor wafers (2) from the respective housings of said support with a third displacement of said gripping arm in said second direction (Y), opposite said first displacement, and
v) displacing said plurality of semiconductor wafers from one place to another in space with three directions or dimensions (X, Y, Z), with displacements of said arm selected from the three spatial directions (X, Y, Z), said step iii) comprising orientating said gripped semiconductor wafers so as to align their respective positioning marks, this occurring simultaneously with the displacements of said gripping arm.

5. Device permitting a change in position of at least one semiconductor wafer (2) provided with at least one positioning mark (3) and placed in a support comprising a plurality of housings superposed in a first direction (Z) perpendicular to the surface of the wafer, said device comprising a single gripping arm and means for displacing said gripping arm, said displacement means comprising:
- a second part (122) permitting said gripping arm to penetrate said housing with a first displacement of said arm in a second spatial direction (Y) parallel to the surface of the wafer,
- a first part (121) permitting said gripping arm (1) a displacement in the first spatial direction (Z) in order to grip said at least one semiconductor wafer by the peripheral part of the latter,
- means permitting said gripping arm (1) a displacement in a third spatial direction (X),
**characterised in that** said gripping arm comprises:
- means for gripping said at least one semiconductor wafer by the peripheral part, said gripping means comprising at least three stops (8) provided respectively with a degree of rotational freedom and distributed around the perimeter of the peripheral part (4) of said at least one semiconductor wafer (2),
- means for orientating said at least one semiconductor wafer, which means co-operate with said gripping means in order to place said positioning mark in a defined position, said orientation means comprising a driving roller (9) for driving said at least one semiconductor wafer by friction, and
- said gripping means (5) and said orientation means (6) being disposed on a rigid structure (7) of the arm..

6. Device according to claim 5, **characterised in that** said gripping arm comprises means for gripping a plurality of semiconductor wafers (2) by the peripheral part, and means for orientating said gripped semiconductor wafers, which means co-operate with said gripping means in order to align said respective positioning marks of said semiconductor wafers.

7. Device according to claim 5, **characterised in that** said driving roller (9) is formed by one of said three stops (8) which is made at least partially drivable.

8. Device according to claim 5 or claim 7, **characterised in that** said positioning mark is a notch (3) placed on the peripheral part (4) of said at least one semiconductor wafer (2), and **in that** said three stops (8) comprise respectively two adjacent and rotationally free driven rollers (8A, 8B).

9. Device according to claim 8, **characterised in that** said driven rollers (8) comprise, respectively, at least one first frustoconical contact surface (16), in order to support said at least one semiconductor wafer (2) by means of a peripheral edge (17) of the latter.

10. Device according to claim 9, **characterised in that** a generatrix of said at least first frustoconical contact surface forms an angle (α) of between 5° and 45° with a perpendicular to said at least one semiconductor wafer (2).

11. Device according to claim 10, **characterised in that** said driven rollers (8) comprise, respectively, a second frustoconical surface (18), the top (19) of which is connected to the base of said first frustoconical surface (16), and the generatrix of which forms an angle with a perpendicular to said at least one semiconductor wafer (2) which is greater than the angle (α) of the generatrix of said first frustoconical surface.

12. Device according to any one of claims 8 to 11, **characterised in that** said orientation means (6) comprise a first light beam (21), capable of being cut when said notch (3) is not opposite said first beam, and a detector (23) which detects that said first beam has been cut.

13. Device according to any one of claims 6 to 12, **characterised in that** it comprises marking means (21, 24) for marking the position of said at least one semiconductor wafer (2) when it is placed in said support.

14. Device according to claims 12 to 13, **characterised in that** said marking means comprise a second light beam (24) which co-operates with said first beam (21) and a feature dimension of said at least one semiconductor wafer (2) in order to establish the position of said at least one semiconductor wafer in said support.

15. Device according to claim 14, **characterised in that** said marking means (21, 24) comprise a third light beam which co-operates with said first light beam (21) or said second light beam (24) and a feature dimension of said at least one semiconductor wafer (2) in order to establish the position of said at least one semiconductor wafer in said support when said first or second beam is placed opposite said notch (3).
